# EUROPEAN PATENT APPLICATION

(11) **EP 1 681 909 A1**
(43) Date of publication of application: **19.07.2006**
(21) Application number: 04773611.1
(22) Date of filing: 29.09.2004
(51) Int. Cl.: H05B 33/22, H05B 33/14

(54) **ORGANIC ELECTROLUMINESCENCE DEVICE**

(30) Priority: 03.10.2003 JP 2003345315
(71) Applicant: Pioneer Corporation, Tokyo 153-0063 (JP)
(72) Inventor: TSUJI, taishi, Pioneer Corporation, Tsurugashima-shi, Saitama 350-2288 (JP)
(74) Representative: Manitz, Finsterwald & Partner GbR
(86) International application number: PCT/JP2004/014674
(87) International publication number: WO 2005/034587

(57) **Abstract**

An organic electroluminescent device comprising a pair of positive and negative electrodes opposed to each other, and an organic functional layer formed between the positive and negative electrodes and having three or more thin films including a light emitting layer made of an organic compound. The organic functional layer comprises a pair of first and second layers and a third layer held between the first and second layers. Each of the first and second layers is made of an organic compound a glass transition temperature of which is equal to or higher than a first temperature, and the third layer is made of an organic compound a glass transition temperature of which is lower than the first temperature. The third layer has a thickness of 30 nm or less.

## Description

### TECHNICAL FIELD

The present invention relates to an organic electroluminescent device (hereinafter referred to as an organic EL device) which has one or more thin films (hereinafter referred to as an organic functional layer) including a light emitting layer. The light emitting layer is made of an organic compound showing electroluminescence in which light is emitted by the application of electric current.

### BACKGROUND ART

An organic EL device basically comprises an organic functional layer including a light emitting layer, and a positive electrode being a display electrode and a negative electrode between which the organic functional layer is sandwiched. When electrons and holes (positive holes) injected from both of the electrodes are recombined, excitons are generated. When the excitons return from an excited state to a ground state, light is emitted. The organic EL device comprises, for example, a transparent positive electrode, an organic functional layer, and a metal negative electrode which are successively laminated on a transparent substrate. The organic functional layer includes a plurality of layers with different functions such as, for example, a hole injection layer, a hole transport layer, a light emitting layer, an electron transport layer, and an electron injection layer which are laminated in this order from the side of the transparent electrode. The hole injection layer and the hole transport layer are made of materials having the function of transporting the holes, and the electron transport layer and the electron injection layer are made of materials having the function of transporting the electrons. These layers exclusive of the light emitting layer are referred to as an electric charge transport layer. The electric charge transport layer increases efficiency in the injection of electric charge into the light emitting layer, and hence significantly improves luminous efficiency as compared with a device comprising only the light emitting layer. Actually, some organic EL devices do not have such an electric charge transport layer, and some organic EL devices have the plurality of such electric charge transport layers. Furthermore, the light emitting layer may comprise a plurality of layers, as with, for example, a white light emitting device having two light emitting layers, that is, a blue light emitting layer and a red light emitting layer.

### DISCLOSURE OF THE INVENTION

Conventionally, there are problems such as non-exhibition of desired emission color due to reciprocal action in materials of the organic functional layer with the lapse of time and low durability.

An object of the present invention is to provide an organic EL device with high reliability.

An organic EL device according to the present invention is an organic electroluminescent device comprising a pair of positive and negative electrodes opposed to each other, and an organic functional layer formed between the positive and negative electrodes and having three or more thin films including a light emitting layer made of an organic compound. The organic functional layer comprises a pair of first and second layers and a third layer held between the first and second layers. Each of the first and second layers is made of an organic compound a glass transition temperature of which is equal to or higher than a first temperature, and the third layer is made of an organic compound a glass transition temperature of which is lower than the first temperature. The third layer has a thickness of 30 nm or less.

### BRIEF DESCRIPTION OF THE DRAWING

Fig. 1 is a diagram showing the configuration of an organic EL device according to an embodiment of the present invention.
Fig. 2 is a diagram showing the configuration of an organic EL device according to another embodiment of the present invention.

### DETAILED DESCRIPTION OF THE INVENTION

If two layers adjacent to each other both made of materials having glass transition temperatures (Tg) in an organic functional layer of an organic EL device, then degradation in luminance, degradation in chromaticity and the like may occur when the device is put in an environment at a high temperature. In view of this circumstance, various prototypes of organic EL devices were fabricated and evaluated. Each organic EL device had an organic functional layer in which a layer made of a material with a low glass transition temperature was sandwiched between layers made of materials with high glass transition temperatures. As a result, it was found that the degradation in luminance occurred when the device was kept in a hot environment for a long period of time, if the difference in glass transition temperature between the sandwiching layers and the sandwiched layers (= the high glass transition temperature - the low glass transition temperature) is insufficient.

For the organic functional layer of the organic EL device, it is difficult to select materials which have fine durability against continuous drive of the device or fine device efficiency in luminous, out of materials with sufficiently high glass transition temperatures. According to the present examples, the decision of thickness within the organic functional layer expands the selection of materials thereof.

An embodiment of the present invention will be hereinafter described with reference to the drawing.

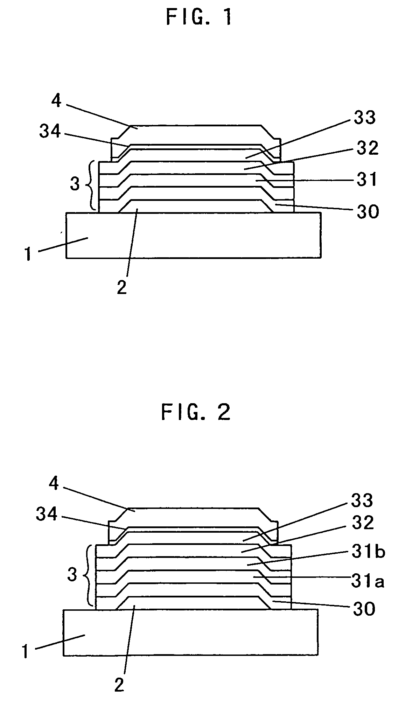

An organic EL device according to the present invention, as shown in Fig. 1, comprises a transparent positive electrode 2, an organic functional layer 3, and a metal negative electrode 4 which are successively laminated on a transparent substrate 1 made of, for example, glass, plastic or the like. Light is emitted from the side of the transparent substrate 1. To take out the emission of the light, at least one of the positive and negative electrodes has to be transparent or translucent. The organic functional layer 3 made of an organic compound comprises a plurality of layers. Each of the plurality of layers has a function as, for example, a hole injection layer 30, a hole transport layer 31, a light emitting layer 32, and an electron transport layer 33 which are laminated from the side of the transparent electrode 2 as shown in Fig. 1. In addition, as shown in Fig. 2, the organic functional layer 3 may be constructed as a stack of a hole injection layer 30 / a first hole transport layer 31a / a second hole transport layer 31b / a light emitting layer 32 / an electron transport layer 33 which are laminated from the side of the transparent electrode 2. An electron injection layer 34 may be provided between the electron transport layer 33 and the metal electrode 4 to increase efficiency in electron injection. Each of the light emitting layer and the electric charge transport layer such as the hole transport layer and the electron transport layer maybe composed of multiple layers.

The transparent electrode 2 has a function as the positive electrode for supplying holes to the organic functional layer. Examples of the material for the positive electrode include metals, alloys, metal oxides, electric conductive compounds, and mixtures thereof. It is preferable to use a material the work function of which is equal to or higher than 4 eV. The positive electrode may be made of, for example, indium tin oxide (ITO), antimony-doped tin oxide (ATO), fluorine-doped tin oxide (FTO), semiconductive metal oxides (tin oxide, zinc oxide, indium oxide, indium zinc oxide (IZO), and the like), metals (gold, silver, chromium, nickel, and the like), mixtures or laminates of the metal and a conductive metal oxide, inorganic conductive materials (copper iodide, copper sulfide, and the like), organic conductive materials (polyaniline, polythiophene, polypyrrole, and the like), laminates of the organic conductive material and ITO, or the like. The thickness of the positive electrode is, for example, approximately 1000 to 300 nm in the case of ITO, and approximately 800 to 150 nm in the case of gold. The thickness of the positive electrode, however, may be appropriately selected in accordance with the kind of material and its transmittance.

The metal electrode 4 has a function as the negative electrode for injecting electrons into the organic functional layer. Examples of the material for the negative electrode include metals , alloys, metal oxides, electric conductive compounds, and mixtures thereof. It is preferable that the metal electrode is made of a material with low resistance such as aluminum. Alternatively, alloys such as a lithium/aluminum alloy and a magnesium/aluminum alloy, or a mixture thereof may be used instead of using only aluminum. To increase the efficiency in electron injection into the organic functional layer, the electron injection layer 34 with a thickness of approximately a few angstroms which is made of LiF (lithium fluoride), Li₂O (lithium oxide), CsF (cesium fluoride) or the like may be inserted. It is preferable that the metal electrode and the electron injection layer, which are adjacent to the organic functional layer, are made of materials the work function of which is equal to or lower than 4.5 eV. For example, an alkali metal (Li, Na, K, Cs, and the like) or an alkaline-earth metal (Mg, Ca, and the like) may be added to the materials. The materials may be used alone, but it is preferable to use two or more types of materials together in order to obtain both of stability and the function of injecting the electrons.

The organic EL device according to the embodiment of the present invention comprises the organic functional layer which is formed between a pair of the positive and negative electrodes opposed to each other. The organic functional layer comprises three or more thin films including the light emitting layer which is made of an organic compound. The organic functional layer includes a pair of first and second layers (e.g., the first hole transport layer 31a and the light emitting layer 32), and a third layer (e.g., the second hole transport layer 31b) held between the first and second layers. Each of the first and second layers is made of an organic compound the glass transition temperature of which is equal to or higher than a first temperature of, for example, 98 °C. The third layer is made of an organic compound the glass transition temperature of which is lower than the first temperature. The third layer is formed to have a thickness of 30 nm or less.

For the organic EL device according to the embodiment of the present invention, its configuration may be set in such a manner that the difference in the glass transition temperature between the adjacent third layer and at least one of the first and second layers is equal to or more than 18 °C. The materials for the first, second, and third layers are selected from materials having the foregoing relation of the glass transition temperatures. This is because the degradation in luminance does not occur even if the organic EL device is kept in the environment at a high temperature for a long period of time, as far as such organic EL device includes the third layer having a thickness of 30 nm or less and the difference in the glass transition temperature between the third layer and the first or second layer is less than 18 °C.

The glass transition temperature indicates the thermal stability of an organic compound. The higher the glass transition temperature, the more thermally stable an amorphous thin film becomes. If the first temperature is 98 °C as a criterion, as with the present embodiment, it is possible to obtain stable emission of light-with long hours of energization due to thermal stability. In consideration of an operating environment and the like under high temperature condition, an effect to a certain extent may be expected even when the first temperature is equal to or higher than 110 °C preferably. The present embodiment adopts values measured by a differential scanning calorimeter.

The sandwiched third layer may be the hole injection layer, the light emitting layer, the electron transport layer or the electron injection layer instead of the hole transport layer, as long as the glass transition temperature of the third layer is lower than those of the sandwiching first and second layers.

Hole transport materials, which make the hole injection layer and the hole transport layer in the organic EL device according to the embodiment of the present invention, are selected from compounds which have the function of transporting holes and injecting holes in addition to the foregoing conditions, and can prevent electrons from moving into the hole transport layer if possible. Examples of the hole transport materials include phthalocyanine derivatives, naphthalocyanine derivatives, porphyrin derivatives, aromatic diamine derivatives such as 4,4'-bis[N-(naphthyl)-N-phenyl-amino]biphenyl (α-NPD), and amine compounds.

Examples of a host material of the light emitting layer in the organic EL device according to the embodiment of the present invention include condensed polycyclic derivatives such as anthracene, naphthalene, pyrene, tetracene, coronene, perylene, phthaloperylene, and naphthaloperylene; and quinolinol metal complexes such as tris(8-hydroxyquinolinato)aluminum, tris(4-methyl-8-quinolinato)aluminum, tris(5-phenyl-8-quinolinato)aluminum, and bis(4-methyl-8-quinolinato)aluminum. For example, BAlq (Tg = 99 °C) represented by the chemical formula (1) described below, Host (Tg = 113 °C) represented by the chemical formula (2) described below, or BEM-B (Tg = 130 °C) represented by the chemical formula (3) described below is used as the host material of the organic light emitting layer.

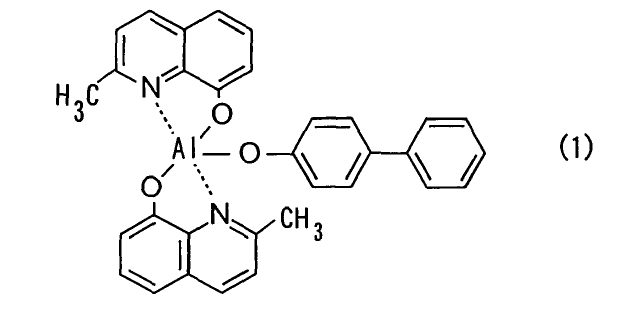

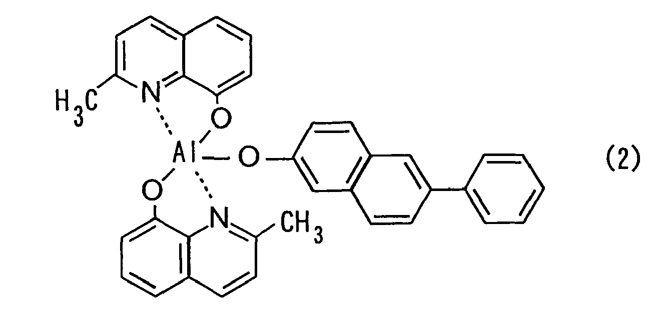

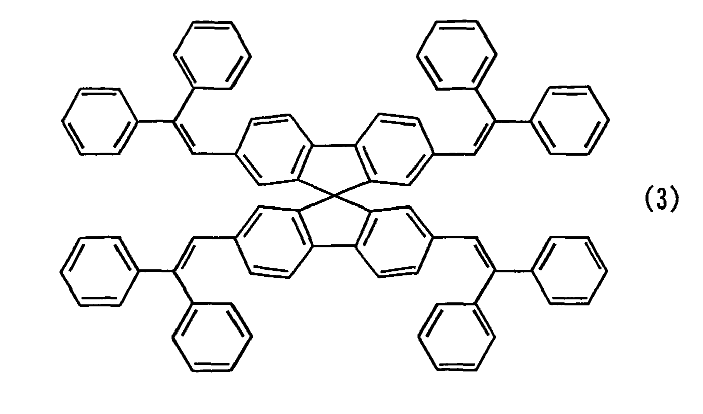

Examples of a doping material for the light emitting layer include fluorescent materials such as a coumarin compound, a quinacridon compound, and a stilamine compound, and phosphorescent materials such as an iridium complex the ligand of which is phenylpyridine, acetylacetone, or the like. For example, BtpIr represented by the chemical formula (4) described below, FIrpic represented by the chemical formula (5) described below or Ir(ppy)3 represented by the chemical formula (6) described below is used as the doping material for the organic light emitting layer.

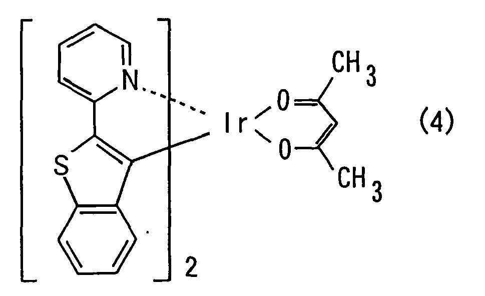

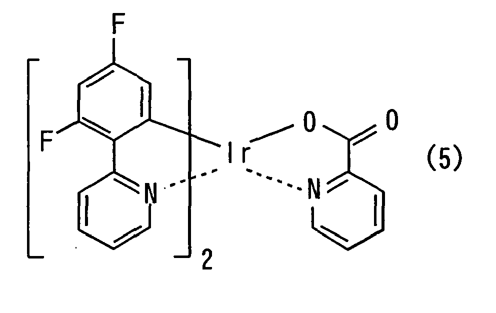

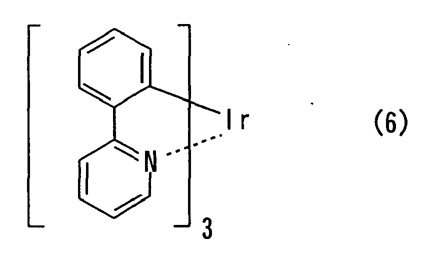

An electron transport material, which makes the electron transport layer in the organic EL device according to the embodiment of the present invention, is selected from compounds which have the function of transporting electrons and injecting electrons in addition to the foregoing conditions, and can prevent holes from moving into the electron transport layer if possible. Examples of the electron transport materials include triazole derivatives, oxazole derivatives, oxadiazole derivatives, fluorenone derivatives, anthraquinodi-methane derivatives, anthorone derivatives, diphenylquinone derivatives, thiopyran dioxide derivatives, carbodiimide derivatives, fluorenylidene methane derivatives, distyrylpyrazine derivatives, heterocyclic tetracarboxylic acid anhydrides such as naphthalene perylene, metal complexes such as a phthalocyanine derivative and a quinolinol derivative, metal complexes the ligand of which is metallophthalocyanine, benzooxazole, benzothiazole, or the like, aniline copolymer, conductive polymers such as thiophene oligomer and polythiophene, polythiophene derivatives, polyphenylene derivatives, polyphenylenevinylene derivatives, and polyfluorene derivatives.

### [Examples]

Concretely, a plurality of samples of an organic EL device were fabricated to evaluate light emission characteristics.

In each sample, the following materials were successively deposited onto an ITO positive electrode (thickness: 110 nm) on a substrate, to fabricate the organic EL device having the following configuration.

Each organic functional layer was laminated as shown in Fig. 1, by using copper phthalocyanine (CuPc) (respective thicknesses: 25 nm) for the hole injection layer, HTM-A (respective thicknesses: 45 nm, 30 nm, 15 nm, 0 nm) for the first hole transport layer, α-NPD (respective thicknesses: 10 nm, 25 nm, 40 nm, 55 nm) for the second hole transport layer, BAlq being a host material to which BtpIr being a dopant material (thickness: 47.5 nm) for the light emitting layer, Alq3 (respective thicknesses: 30 nm) for the electron transport layer. CuPc being a hole injection material is thermally stable, and both of the glass transition temperature and the melting point thereof are not observed up to 300 °C in thermal analysis. HTM-A is a hole transport material the glass transition temperature of which is 120 °C. BAlq in the light emitting layer has a glass transition temperature of 99 °C. BtpIr is a phosphorescent dopant. Alq3 functioning as an electron transport material has a glass transition temperature of 167 °C.

Then, in each sample, LiF was evaporated on the electron transport layer as an electron injection layer to have a thickness of 1 nm. Furthermore, aluminum (Al) was laminated thereon as a negative electrode with a thickness of 100 nm, to fabricate the samples of organic light emitting devices of the example.

The table 1 shows the thickness states of the organic functional layers of four examples 1 to 4.

**Table 1**

| Sample | Thicknesses of organic functional layers (nm) | | | | |
|---|---|---|---|---|---|
| | CuPc(Tg⇒300°C) | HTM-A(Tg=120°C) | α-NPD(Tg=96°C) | BAlq(Tg=99°C)+Btplr | Alq3(Tg=167°C) |
| 1 | 25 | 45 | 10 | 47.5 | 30 |
| 2 | 25 | 30 | 25 | 47.5 | 30 |
| 3 | 25 | 15 | 40 | 47.5 | 30 |
| 4 | 25 | 0 | 55 | 47.5 | 30 |

The samples of organic EL devices were kept in the thermostatic chamber at 100 °C for a predetermined time (hours) respectively. The table 2 shows variations in chromaticity and luminous efficiency (cd/A) of the devices, when the devices were driven with 5.5 mA/cm² after that.

**Table 2**

| Sample | Hole transport layer: thickness | Elapsed time (hr) at 100°C | Chromaticity | | Lumi. effi. (cd/A) |
|---|---|---|---|---|---|
| | | | CIEx | CIEy | |
| 1 | HTM-A:45nm α-NPD:10nm | 0 | 0.679 | 0.321 | 6.3 |
| | | 20 | 0.677 | 0.322 | 6.3 |
| | | 80 | 0.674 | 0.325 | 6.6 |
| | | 150 | 0.670 | 0.328 | 5.5 |
| 2 | HTM-A:30nm α-NPD:25nm | 0 | 0.678 | 0.321 | 6.4 |
| | | 20 | 0.679 | 0.321 | 6.3 |
| | | 80 | 0.673 | 0.325 | 6.2 |
| | | 150 | 0.659 | 0.334 | 3.6 |
| 3 | HTM-A: 15nm α-NPD:40nm | 0 | 0.677 | 0.321 | 6.3 |
| | | 20 | 0.678 | 0.321 | 6.3 |
| | | 80 | 0.673 | 0.325 | 5.6 |
| | | 150 | 0.643 | 0.345 | 2.2 |
| 4 | HTM-A:0nm α-NPD:55nm | 0 | 0.678 | 0.321 | 6.5 |
| | | 20 | 0.678 | 0.321 | 6.3 |
| | | 80 | 0.674 | 0.324 | 5.0 |
| | | 150 | 0.605 | 0.369 | 1.3 |

As apparent from the table 2, the chromaticitiy did not vary without reduction by half of the luminous efficiency in the device samples 1 and 2, even after the devices were kept in the thermostatic chamber at 100 °C for 150 hours. As compared with them, in the comparative device samples 3 and 4, its chromaticitiy varied greatly with reduction by half of the luminous efficiency. In the present example, the layer of HTM-A (glass transition temperature of 120 °C) is deposited between the CuPc layer and the α-NPD layer in such a manner that the α-NPD layer becomes thin. Besides the thermally stable CuPc layer may be formed to be fat and the α-NPD layer thin.

As other experiences, organic EL device samples 5 and 6 were fabricated in a similar manner to the above-mentioned example, except that the thicknesses were set as shown in the table 3 below and the foregoing Host having a glass transition temperature of 113 °C was used as the host material in the light emitting layer instead of BAlq.

**Table 3**

| Sample | Thicknesses of organic functional layers(nm) | | | | |
|---|---|---|---|---|---|
| | CuPc(Tg=>300°C) | HTM-A(Tg=120°C) | α-NPD(Tg=96°C) | Host(Tg=113°C)+Btp | Alq3(Tg=167°C) |
| 5 | 25 | 30 | 25 | 40 | 37.5 |
| 6 | 25 | 0 | 55 | 40 | 37.5 |

The foregoing device samples were kept in the thermostatic chamber at 100 °C for a predetermined time (hours) respectivly. The table 4 shows variations in chromaticity and luminous efficiency (cd/A) of the devices, when the devices were driven with 5.5 mA/cm² after that.

**Table 4**

| Sample | Hole transport layer: thickness | Elapsed time (hr) at 100°C | Chromaticity | | Lumi. effi. (cd/A) |
|---|---|---|---|---|---|
| | | | CIEx | CIEy | |
| 5 | HTM-A:30nm α-NPD:25nm | 0 | 0.680 | 0.319 | 6.6 |
| | | 150 | 0.678 | 0.321 | 6.8 |
| | | 300 | 0.674 | 0.323 | 6.2 |
| | | 500 | 0.673 | 0.324 | 5.9 |
| 6 | HTM-A:0nm α-NPD:55nm | 0 | 0.678 | 0.320 | 6.4 |
| | | 150 | 0.675 | 0.323 | 5.4 |
| | | 300 | 0.675 | 0.323 | 5.0 |
| | | 500 | 0.672 | 0.326 | 3.6 |

As apparent from the table 4, the luminous efficiency of the example of device sample 5 decreased by only 10 %, even after the devices were kept in the thermostatic chamber at 100 °C for 500 hours. In the comparative example of device sample 6, as compared with them, the luminous efficiency decreased by 44 % after the 500 hours preserved.

Since the organic EL device is structured in the manner of the present embodiments, problems such as degradation in luminance and variation in chromaticity do not occur even if the device is kept in an environment at a high temperature. Also, there is an effect that the selection of materials becomes easy. In particular, applying the present invention improves the reliability of a product which is on the premise of being mounted on a vehicle.

## Claims

1. An organic electroluminescent device comprising: a pair of positive and negative electrodes opposed to each other; and an organic functional layer formed between the positive and negative electrodes and having three or more thin films including a light emitting layer made of an organic compound, **characterized in that** the organic functional layer includes a pair of first and second layers and a third layer held between the first and second layers, each of the first and second layers being made of an organic compound a glass transition temperature of which is equal to or higher than a first temperature, the third layer being made of an organic compound a glass transition temperature of which is lower than the first temperature, and the third layer having a thickness of 30 nm or less.

2. The organic electroluminescent device according to claim 1, wherein the glass transition temperature of the third layer is in a range satisfying that the difference in the glass transition temperature between the third layer and the first or second layer is less than 18 °C.

3. The organic electroluminescent device according to claim 1 or 2, wherein the first temperature is 98 °C.

4. The organic electroluminescent device according to any one of claims 1-3, wherein the third layer is made of a material having a function of transporting holes.
